# EUROPÄISCHE PATENTSCHRIFT

(11) **EP 3 336 906 B1**
(45) Veröffentlichungstag und Bekanntmachung des Hinweises auf die Patenterteilung: **10.04.2019**
(21) Anmeldenummer: 17002021.8
(22) Anmeldetag: 12.12.2017
(51) Int. Cl.: H01L 33/00, H01L 31/0304, H01L 31/18, H01L 29/20, H01L 21/02, H01L 21/18, H01L 21/265

(54) **HERSTELLUNGSVERFAHREN EINES SCHICHTSTAPELS AUS EINEM P+ SUBSTRAT, EINER P-SCHICHT, EINER N-SCHICHT UND EINER DRITTEN SCHICHT**
METHOD OF MANUFACTURING A STACK FROM A P+SUBSTRATE, A P-TYPE LAYER, AN N-TYPE LAYER AND A THIRD LAYER
PROCÉDÉ DE FABRICATION D'UN EMPILEMENT DE COUCHES EN UN SUBSTRAT P+, D'UNE COUCHE P, D'UNE COUCHE N ET D'UNE TROISIÈME COUCHE

(30) Priorität: 17.12.2016 DE 102016015056
(43) Veröffentlichungstag der Anmeldung: 20.06.2018
(73) Patentinhaber: 3-5 Power Electronics GmbH, 01217 Dresden (DE)
(72) Erfinder: Dudek, Volker, 76275 Ettlingen (DE)
(74) Vertreter: Koch Müller Patentanwaltsgesellschaft mbH

(56) Entgegenhaltungen:
- CN-A- 101 950 774
- CN-A- 103 219 414
- CN-A- 103 700 712
- CN-A- 104 701 162
- US-A1- 2016 204 306
- SHI FRANK ET AL: "Characterization of GaAs-based n-n and p-n interface junctions prepared by direct wafer bonding", JOURNAL OF APPLIED PHYSICS, AMERICAN INSTITUTE OF PHYSICS, US, Bd. 92, Nr. 12, 15. Dezember 2002 (2002-12-15), Seiten 7544-7549, XP012056825, ISSN: 0021-8979, DOI: 10.1063/1.1522484

## Beschreibung

Die Erfindung betrifft eine Herstellungsverfahren eines Schichtstapels aus einem p⁺-Substrat, einer p⁻-Schicht, einer n⁻-Schicht und einer dritten Schicht. Aus "GaAs Power Devices" von German Ashkinazi, ISBN 965-7094-19-4, ist eine hochspannungsfeste Halbleiterdiode p⁺ - n - n⁺ (Seite 8 und 9) bekannt, wobei die n⁻ und die n⁺-Schicht mittels Flüssigphasenepitaxie zwischen zwei p⁺-Substraten erzeugt sind. In Kapitel 3, S. 22- S. 26 ist eine Schottky-Diode mit einem GaAs umfassenden epitaktischen Schichtaufbau mit n⁺-Substrat und einer Nickel umfassenden Schicht zur Ausbildung des Schottky-Kontakts beschrieben.

Aus der EP 2 645 431 A1 ist ein Herstellungsverfahren für eine Tandemsolarzelle aus zwei oder mehr Solarzellen bekannt, wobei mindestens eine erste Solarzelle auf einem Basis-Substrat-Aufbau erzeugt wird, eine zweite Solarzelle auf einem Hilfs-Substrat erzeugt wird und die beiden Solarzellen anschließend mittels Waferbonden stoffschlüssig miteinander verbunden werden.

Aus "Characterization of GaAs-based n-n and p-n interface junctions prepared by direct wafer bonding" von Shi Frank et al., J. of Appl. Phys., Bd. 92, Nr. 12, Seiten 7544-7549, ISSN: 0021-8979, ist ein Herstellungsverfahren für einer GaAs pn-Übergang bekannt, wobei die pn-Übergang mittels Waferbonden erzeugt wird.

Vor diesem Hintergrund besteht die Aufgabe der Erfindung darin, eine Vorrichtung anzugeben, die den Stand der Technik weiterbildet.

Die Aufgabe wird durch ein Herstellungsverfahren mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Herstellungsverfahren für einen Schichtstapel umfassend ein p⁺-Substrat, eine p⁻-Schicht, eine n⁻-Schicht und eine dritte Schicht bereitgestellt.

Das p⁺-Substrat weist eine Dotierstoffkonzentration von 1*10¹⁸-5*10²⁰cm⁻³ und eine Schichtdicke von 50-500 µm auf und umfasst eine GaAs-Verbindung oder besteht aus einer GaAs-Verbindung.

Die p⁻Schicht weist eine Dotierstoffkonzentration von 10¹⁴-10¹⁶ cm⁻³ und eine Schichtdicke von 0,01-30µm auf und umfasst eine GaAs-Verbindung oder besteht aus einer GaAs-Verbindung.

Die n⁻-Schicht weist eine Dotierstoffkonzentration von 10¹⁴-10¹⁶ cm⁻³, eine Schichtdicke von 10-200 µm auf und umfasst eine GaAs-Verbindung oder besteht aus einer GaAs-Verbindung.

Ein erster Teilstapel und ein zweiter Teilstapel wird erzeugt und eine Oberseite des ersten Teilstapels mit einer Oberseite des zweiten Teilstapels durch Waferbonden stoffschlüssig verbunden, um den Schichtstapel zu erzeugen.

Der erste Teilstapel umfasst zumindest das p⁺-Substrat, während der zweite Teilstapel zumindest die n⁻-Schicht umfasst.

Die p⁻-Schicht wird durch Epitaxie, z.B. LPE oder MOVPE, oder durch Implantation auf einer Oberseite des p⁺-Substrats oder durch Epitaxie auf der n⁻-Schicht erzeugt und bildet die Oberseite des ersten Teilstapels oder des zweiten Teilstapels. Die dritte Schicht wird vor oder nach dem Waferbonden erzeugt.

Vorzugsweise weist die p⁻-Schicht eine Dotierung kleiner als 10¹³ N/cm⁻³ oder eine Dotierung zwischen 10¹³ N/cm⁻³ und 10¹⁵ N/cm⁻³ auf. In einer Ausführungsform wird das p⁺-Substrat vor oder nach dem Bonden durch einen Schleifprozess auf eine Dicke zwischen 200 µm und 500 µm gedünnt.

In einer ersten Alternative wird die n⁻-Schicht nach dem Waferbonden durch Abschleifen eines den zweiten Teilstapel zumindest teilweise bildenden n⁻-Substrats erzeugt, in dem ausgehend von einem n⁻-Substrat, das n⁻-Substrat mit dem ersten Stapel durch einen Waferbondprozess verbunden wird. In einem nachfolgenden Prozessschritt wird das n⁻-Substrat und hierdurch die n⁻-Schicht auf die gewünschte Dicke gedünnt.

In einer zweiten Alternative wird die n⁻-Schicht vor dem Waferbonden auf einem n⁺-Substrat epitaktisch erzeugt.

Vorzugsweise liegt die Dicke des der n⁻-Schicht in einem Bereich zwischen 50 µm bis 250µm.

Vorzugsweise liegt die Dotierung der n⁻-Schicht in einem Bereich zwischen 10¹³ N/cm⁻³ und 10¹⁵ N/cm⁻³.

Ein Vorteil des Herstellens der n⁻-Schicht mittels des weiteren Waferbondens ist es, dass sich dicke n-Schichten ohne weiteres herstellen lassen. Ein langer Abscheideprozess bei der Epitaxie entfällt hierdurch. Auch lassen sich mittels des weiteren Waferbondprozesses die Anzahl der Stapelfehler verringern.

In eine alternativen Ausführungsform weist die n⁻-Schicht eine Dotierung größer als 10¹⁰ N/cm⁻³ und kleiner als 10¹³ N/cm⁻³ auf. In dem die Dotierung extrem gering ist, lässt sich die n⁻-Schicht auch als eine intrinsische Schicht auffassen.

In einer anderen Weiterbildung wird nach dem Dünnen des n⁻-Substrats mittels Epitaxie oder Hochdosisimplantation auf dem n⁻-Substrat die n⁺-Schicht in einem Bereich zwischen 10¹⁸ N/cm⁻³ und kleiner als 5x10¹⁹ N/cm⁻³ erzeugt. Das Dünnen des n⁻-Substrats erfolgt vorzugsweise mittels eines CMP Schrittes, d.h. mittels chemischen mechanischen Polierens.

Es wird angemerkt, dass der Ausdruck Waferbond synonym mit dem Ausdruck Halbleiterbond verwendet wird. Vorzugsweise ist der erste Teilstapel monolithisch und vorzugsweise ist der zweite Teilstapel ebenfalls monolithisch ausgebildet.

Es versteht sich, dass es sich bei dem Substrat und der ersten Schicht und der zweiten Schicht um III-V Halbleiterschichten handelt, wobei in einer Weiterbildung die Schichten und das Substrat die jeweils gleich Gitterkonstante aufweisen und vorzugsweise das gleiche Halbleitermaterial, insbesondere GaAs umfassen.

Ein Vorteil ist, dass durch das Waferbonden und durch die p⁻-Zwischenschicht die Qualität der Kristallstruktur des erzeugten Schichtstapels im Vergleich zu beispielsweise nur durch Epitaxie und/oder ohne Zwischenschicht erzeugte Stapel gerade für die dicken Halbleiterschichten eine hohe Schichtqualität erzielen lässt. Insbesondere lassen sich Schichtstapel mit wenigen Versetzungen erzeugen. Hierdurch erhöht sich insbesondere bei den n⁻-Schichten sich die Ladungsträgerlebensdauer erheblich. Es ist auch möglich in der p-Zwischenschicht vor dem Waferbonden Rekombinationszentren einzubringen, um die Lebensdauer der Ladungen in der p-Zwischenschicht zu beeinflussen.

Ein Vorteil des Abtrennens der n⁻-Schicht ist es, dass der Träger, bzw. das n⁻-Substrat des zweiten Teilstapels mehrfach wiederverwenden lässt.

Entsprechendes gilt auf für das n⁺-Substrat, d.h. durch Abtrennen einer dünnen n⁺-Schicht lässt sich das n⁺-Substrat wiederverwenden. Vorzugsweise lässt sich vor dem Abtrennen einer dünnen n⁺-Schicht auch die n⁻-Schicht epitaktisch herstellen. Anders ausgedrückt wird, in einer Weiterbildung die n⁺-Schicht als direkt an die n⁻-Schicht angrenzender Bereich des n⁺-Substrats zusammen mit der n⁻Schicht vor dem Waferbonden von dem n⁺-Substrat abgetrennt.

In einer Weiterbildung wird die vor dem Waferbonden erzeugte n⁻-Schicht vor dem Abtrennen durch Epitaxie, z.B. LPE oder MOVPE, auf einem n⁺-Substrat oder durch Implantation innerhalb eines n⁺-Substrats erzeugt.

Gemäß einer alternativen Weiterbildung ist die dritte Schicht als n⁺-Schicht mit einer Dotierstoffkonzentration von mindestens 5*10¹⁸cm⁻³, einer Schichtdicke kleiner 20 µm und umfassend eine GaAs-Verbindung oder bestehend aus einer GaAs-Verbindung ausgebildet.

Die n⁺-Schicht lässt sich nach dem Waferbonden durch Epitaxie auf der durch Abschleifen erzeugten n⁻-Schicht oder durch Implantation in der durch Abschleifen erzeugten n⁻-Schicht.

In einer Weiterbildung wird die n⁻-Schicht mittels Implantation von Störstellen von einem n⁻-Substrat abgetrennt.

Das Abtrennen der n⁻-Schicht und / oder der n⁺-Schicht von dem n⁺-Substrat erfolgt gemäß einer anderen Ausführungsform durch Implantation von Störstellen.

Gemäß einer alternativen Ausführungsform umfasst die dritte Schicht ein Metall oder eine metallische Verbindung oder besteht aus einem Metall oder einer metallischen Verbindung.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: eine schematische Ansicht auf eine erste Ausführungsform eines erfindungsgemäßen Herstellungsverfahrens,
- Figur 2: eine schematische Ansicht auf eine zweite Ausführungsform eines erfindungsgemäßen Herstellungsverfahrens,
- Figur 3A,B: eine schematische Ansicht auf eine dritte Ausführungsform eines erfindungsgemäßen Herstellungsverfahrens

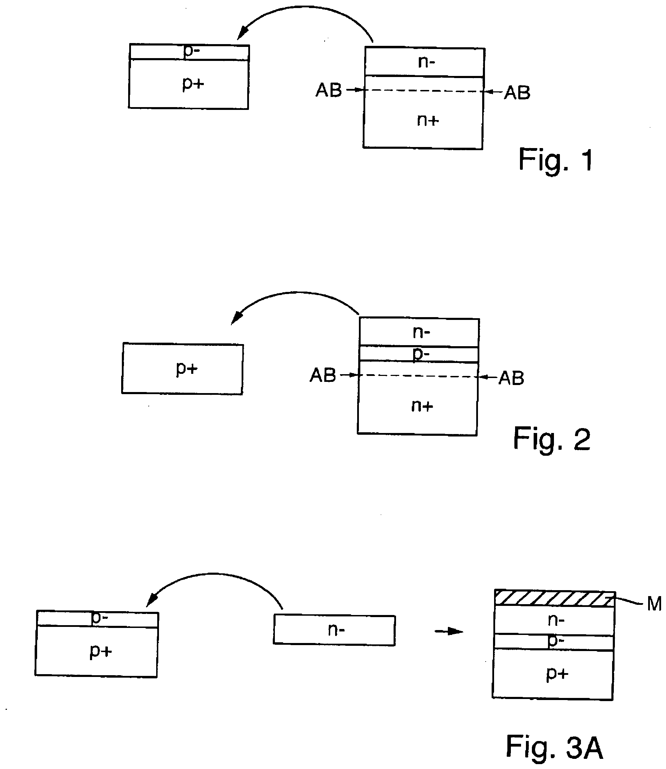

- Figur 2: eine schematische Ansicht auf eine vierte Ausführungsform eines erfindungsgemäßen Herstellungsverfahrens.

Die Abbildung der Figur 1 zeigt eine Ansicht einer ersten Ausführungsform des erfindungsgemäßen Herstellungsverfahrens.

Auf einem p+-Substrat mit einer Dotierstoffkonzentration von 5*10¹⁸-5*10²⁰cm⁻³ und einer Schichtdicke von 50-500 µm wird eine p--Schicht mit einer Dotierstoffkonzentration von 10¹⁴-10¹⁶ cm⁻³ und eine Schichtdicke von 0,01-30 µm erzeugt, wobei sowohl das p⁺-Substrat als auch die p--Schicht eine GaAs-Verbindung umfassen oder aus einer GaAs Verbindung bestehen.

Die Schichtenfolge aus p+-Substrat und p--Schicht bilden einen ersten Teilstapel, wobei die p--Schicht eine Oberseite des Teilstapels ausbildet.

Auf einem n+-Substrat mit einer Dotierstoffkonzentration von mindestens 5*10¹⁸cm⁻³ wird durch Epitaxie, z.B. durch Flüssigphasenepitaxie oder MOVPE, eine n--Schicht mit einer Dotierstoffkonzentration von 10¹²-10¹⁶ cm⁻³ und einer Schichtdicke von 10-300 µm erzeugt, wobei das n+-Substrat sowie die n--Schicht eine GaAs-Verbindung umfassen oder aus einer GaAs Verbindung bestehen.

Anschließend wird die n--Schicht zusammen mit einem sich direkt an die n--Schicht anschließenden ersten Bereich des n+-Substrats von dem n+-Substrat an der Stelle AB abgelöst. Das Ablösen erfolgt beispielsweise durch Implantation von Fehlstellen in dem n+-Substrat.

Der abgelöste Bereich des n+-Substrats bildet eine dritte Schicht des Schichtstapels und weist eine Schichtdicke kleiner als 30 µm auf. Die Schichtenfolge aus n--Schicht und n+-Schicht bildet einen zweiten Teilstapel, wobei die n--Schicht eine Oberseite des Teilstapels ausbildet.

Die Oberseite des ersten Teilstapels wird mit der Oberseite des zweiten Teilstapels durch Waferbonden stoffschlüssig verbunden, d.h. die nach dem Ablösen vorliegende Schichtenfolge aus n⁻-Schicht und n+-Schicht wird mit einer Oberseite der n⁻-Schicht auf die Oberseite der p--Schicht aufgebracht und die beiden Oberseiten werden durch Waferbonden miteinander stoffschlüssig verbunden.

In der Abbildung der Figur 2 ist eine zweite Ausführungsform des erfindungsgemäßen Herstellungsverfahrens dargestellt. Im Folgenden werden nur die Unterschiede zu der Abbildung der Figur 1 erläutert.

Gemäß der zweiten Ausführungsform wird die p--Schicht durch Epitaxie auf einer Oberseite der n⁻-Schicht erzeugt und bildet die Oberseite des zweiten Teilstapels aus, während der erste Teilstapel nur das p+-Substrat umfasst.

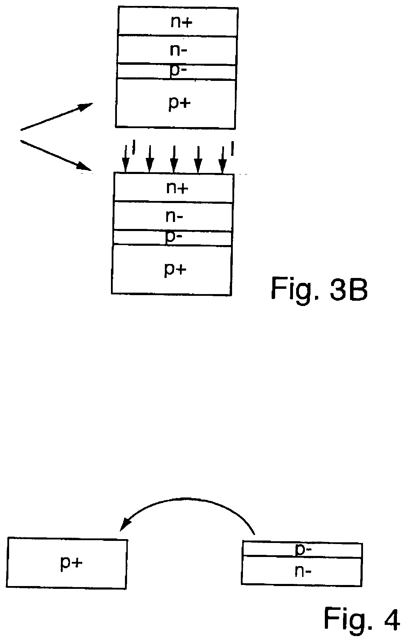

In der Abbildung der Figuren 3A und 3B ist eine dritte Ausführungsform des erfindungsgemäßen Herstellungsverfahrens dargestellt. Im Folgenden werden nur die Unterschiede zu der Abbildung der Figur 1 erläutert.

Gemäß der dritten Ausführungsform wird der erste Teilstapel wie in der ersten Ausführungsform aus dem p+-Substrat und der p-Schicht gebildet. Der zweite Teilstapel wird aus einem n--Substrat gebildet. Die n--Schicht wird nach dem stoffschlüssigen Verbinden des ersten Teilstapels mit dem zweiten Teilstapel durch Abschleifen des n--Substrats auf eine gewünschte Schichtdicke erzeugt.

Die dritte Schicht wird nach dem Abschleifen auf die Oberseite der n-Schicht aufgebracht und mit der Oberseite stoffschlüssig verbunden, z.B. durch Epitaxie. Alternativ wird die dritte Schicht in der n⁻-Schicht gebildet durch eine Implantation I von Dotierstoffen in die Oberfläche der n⁻-Schicht. Die dritte Schicht ist eine n⁺-Schicht. Alternativ besteht die dritte Schicht aus einem Metall oder einer metallische Verbindung oder umfasst ein Metall oder eine metallische Verbindung.

In der Abbildung der Figur 4 ist eine vierte Ausführungsform des erfindungsgemäßen Herstellungsverfahrens dargestellt. Im Folgenden werden nur die Unterschiede zu den Abbildungen der vorangegangenen Figuren erläutert.

Die vierte Ausführungsform entspricht der dritten Ausführungsform mit dem Unterschied, dass die p--Schicht durch Epitaxie auf dem n--Substrat erzeugt wird.

## Patentansprüche

1. Herstellungsverfahren eines Schichtstapels aus einem p⁺-Substrat, einer p⁻-Schicht, einer n⁻-Schicht und einer dritten Schicht, wobei
- das p⁺-Substrat eine Dotierstoffkonzentration von 5*10¹⁸-5*10²⁰cm⁻³ und eine Schichtdicke von 50-900 µm aufweist und eine GaAs-Verbindung umfasst oder aus einer GaAs-Verbindung besteht,
- die p⁻-Schicht eine Dotierstoffkonzentration von 10¹⁴-10¹⁶ cm⁻³ und eine Schichtdicke von 0,01-1 µm aufweist und eine GaAs-Verbindung umfasst oder aus einer GaAs-Verbindung besteht,
- die n⁻-Schicht eine Dotierstoffkonzentration von 10¹⁴-10¹⁶ cm⁻³, eine Schichtdicke von 10-200 µm aufweist und eine GaAs-Verbindung umfasst oder aus einer GaAs-Verbindung besteht,
- ein erster Teilstapel und ein zweiter Teilstapel erzeugt wird und eine Oberseite des ersten Teilstapels mit einer Oberseite des zweiten Teilstapels durch Waferbonden stoffschlüssig verbunden werden, um den Schichtstapel zu erzeugen,
- der erste Teilstapel zumindest das p⁺-Substrat umfasst,
- der zweite Teilstapel zumindest die n⁻-Schicht umfasst,
- die p⁻-Schicht durch Epitaxie oder Implantation auf einer Oberseite des p⁺-Substrats oder durch Epitaxie auf der n⁻-Schicht erzeugt wird und die p⁻-Schicht die Oberseite des ersten Teilstapels oder des zweiten Teilstapels bildet,
- die dritte Schicht vor oder nach dem Waferbonden erzeugt wird,
- die n⁻-Schicht in einer ersten Alternative nach dem Waferbonden durch Abschleifen eines den zweiten Teilstapel zumindest teilweise bildenden n⁻-Substrats erzeugt wird oder in einer zweiten Alternative die n⁻-Schicht vor dem Waferbonden auf einem n⁺-Substrat erzeugt wird.

2. Herstellungsverfahren nach Anspruch 1, **dadurch gekennzeichnet, dass** die vor dem Waferbonden auf dem n⁺-Substrat erzeugte n⁻-Schicht durch Epitaxie auf einem n⁺-Substrat erzeugt wird.

3. Herstellungsverfahren nach Anspruch 1 oder 2, **dadurch gekennzeichnet, dass** die dritte Schicht als n⁺-Schicht mit einer Dotierstoffkonzentration von mindestens 10¹⁹cm⁻³, einer Schichtdicke kleiner 30 µm und umfassend eine GaAs-Verbindung oder bestehend aus einer GaAs-Verbindung ausgebildet ist.

4. Herstellungsverfahren nach Anspruch 3, **dadurch gekennzeichnet, dass** die n⁺-Schicht nach dem Waferbonden durch Epitaxie auf der durch Abschleifen erzeugten n⁻-Schicht oder durch Implantation in der durch Abschleifen erzeugten n⁻-Schicht oder durch Abtrennen von dem n⁺-Substrat erzeugt wird.

5. Herstellungsverfahren nach Anspruch 4, **dadurch gekennzeichnet, dass** die n⁺-Schicht als direkt an die n⁻-Schicht angrenzender Bereich des n⁺-Substrats zusammen mit der n⁻-Schicht vor dem Waferbonden von dem n⁺-Substrat abgetrennt wird.

6. Herstellungsverfahren nach einem der Ansprüche 1 bis 5, **dadurch gekennzeichnet, dass** die n⁻-Schicht mittels Implantation von Störstellen von einem n⁻-Substrat abgetrennt wird.

7. Herstellungsverfahren nach einem der Ansprüche 1 bis 5, **dadurch gekennzeichnet, dass** die n⁻-Schicht mittels Implantation von Störstellen oder und / oder die n⁺-Schicht durch Implantation von Störstellen von dem n⁺-Substrat abgetrennt werden.

8. Herstellungsverfahren nach Anspruch 1 oder 2, **dadurch gekennzeichnet, dass** die dritte Schicht ein Metall oder eine metallische Verbindung umfasst oder aus einem Metall oder einer metallischen Verbindung besteht.

## Claims

1. Method of manufacturing a layered stack from a p⁺ substrate, a p⁻ layer, an n⁻ layer and a third layer, wherein
- the p⁺ substrate has a doping substance concentration of 5∗10¹⁸ - 5∗10²⁰ cm⁻³ and a layer thickness of 50 - 900 µm and comprises a GaAs compound or consists of a GaAs compound,
- the p⁻ layer has a doping substance concentration of 10¹⁴ - 10¹⁶ cm⁻³ and a layer thickness of 0.01 -1 µm and comprises a GaAs compound or consists of a GaAs compound,
- the n- layer has a doping substance concentration of 10¹⁴ - 10¹⁶ cm⁻³, and a layer thickness of 10 - 200 µm and comprises a GaAs compound or consists of a GaAs compound,
- a first part stack and a second part stack are produced and an upper side of the first part stack is connected by material couple with an upper side of the second part stack by wafer bonding so as to produce the layered stack,
- the first part stack comprises at least the p⁺ substrate,
- the second part stack comprises at least the n⁻ layer,
- the p⁻ layer is produced by epitaxy or implantation on an upper side of the p⁺ substrate or by epitaxy on the n⁻ layer and the p⁻ layer forms the upper side of the first part stack or of the second part stack,
- the third layer is produced before or after the wafer bonding and
- in a first alternative the n⁻ layer is produced, after the wafer bonding, by grinding off a n⁻ substrate at least partly forming the second part stack or in a second alternative, the n⁻ layer is formed, before the wafer bonding, on an n⁺ substrate.

2. Method of manufacturing according to claim 1, **characterised in that** the n⁻ layer produced on the n⁺ substrate before the wafer bonding is produced by epitaxy on an n⁺ substrate.

3. Method of manufacturing according to claim 1 or 2, **characterised in that** the third layer is formed as an n⁺ layer with a doping substance concentration of at least 10¹⁹ cm⁻³ and a layer thickness smaller than 30 µm and comprises a GaAs compound or consists of a GaAs compound.

4. Method of manufacturing according to claim 3, **characterised in that** the n⁺ layer is produced, after the wafer bonding, by epitaxy on the n⁻ layer produced through the grinding away or by implantation in the n⁻ layer produced through the grinding away or by separation from the n⁺ substrate.

5. Method of manufacturing according to claim 4, **characterised in that** the n⁺ layer is separated from the n⁺ substrate as a region, which directly adjoins the n⁻ layer, of the n⁺ substrate together with the n⁻ layer prior to the wafer bonding.

6. Method manufacturing according to any one of claims 1 to 5, **characterised in that** the n⁻ layer is separated from an n⁻ substrate by means of implantation of frangible locations.

7. Method of manufacturing according to any one of claims 1 to 5, **characterised in that** the n⁻ layer is separated from the n⁺ substrate by means of implantation of frangible locations and/or the n⁺ layer is separated from the n⁺ substrate by implantation of frangible locations.

8. Method manufacturing according to claim 1 or 2, **characterised in that** the third layer comprises a metal or a metallic compound or consists of a metal or a metallic compound.

## Revendications

1. Procédé de fabrication d'un empilement de couches en un substrat p+, une couche p⁻, une couche n⁻ et une troisième couche, dans lequel
- le substrat p⁺ présente une concentration de substance dopante de 5*10¹⁸-5*10²⁰ cm⁻³ et une épaisseur de couche de 50-900 µm et comprend un composé GaAs ou se compose d'un composé GaAs,
- la couche p⁻ présente une concentration de substance dopante de 10¹⁴-10¹⁶ cm⁻³ et une épaisseur de couche de 0,01-1 µm et comprend un composé GaAs ou se compose d'un composé GaAs,
- la couche n⁻ présente une concentration de substance dopante de 10¹⁴-10¹⁶ cm⁻³ et une épaisseur de couche de 10-200 µm et comprend un composé GaAs ou se compose d'un composé GaAs,
- on produit un premier empilement partiel et un second empilement partiel et on assemble un côté supérieur du premier empilement partiel avec un côté supérieur du second empilement partiel matériellement par collage de plaquettes, afin de produire l'empilement de couches,
- le premier empilement partiel comprend au moins le substrat p⁺,
- le second empilement partiel comprend au moins la couche n⁻,
- on produit la couche p⁻ par épitaxie ou implantation sur un côté supérieur du substrat p⁺ ou par épitaxie sur la couche n⁻, et la couche p⁻ forme le côté supérieur du premier empilement partiel ou du second empilement partiel,
- on produit la troisième couche avant ou après le collage de plaquettes,
- on produit la couche n⁻ selon une première alternative après le collage de plaquettes par ponçage d'un substrat n- formant au moins partiellement le second empilement partiel ou on produit la couche n- selon une seconde alternative avant le collage de plaquettes sur un substrat n+.

2. Procédé de fabrication selon la revendication 1, **caractérisé en ce que** l'on produit la couche n⁻ produite sur le substrat n⁺ avant le collage de plaquettes par épitaxie sur un substrat n⁺.

3. Procédé selon la revendication 1 ou 2, **caractérisé en ce que** la troisième couche est réalisée sous forme de couche n⁺ avec une concentration de substance dopante d'au moins 10¹⁹ cm⁻³, une épaisseur de couche inférieure à 30 µm et comprenant un composé GaAs ou se composant d'un composé GaAs.

4. Procédé de fabrication selon la revendication 3, **caractérisé en ce que** l'on produit la couche n⁺ après le collage de plaquettes par épitaxie sur la couche n⁻ produite par ponçage ou par implantation dans la couche n⁻ produite par ponçage ou par séparation du substrat n⁺.

5. Procédé de fabrication selon la revendication 4, **caractérisé en ce que** l'on sépare la couche n⁺ du substrat n⁺ sous forme de région du substrat n⁺ adjacente à la couche n⁻ de concert avec la couche n⁻ avant le collage de plaquettes.

6. Procédé selon l'une quelconque des revendications 1 à 5, **caractérisé en ce que** l'on sépare la couche n⁻ d'un substrat n⁻ au moyen de l'implantation de défauts.

7. Procédé de fabrication selon l'une quelconque des revendications 1 à 5, **caractérisé en ce que** l'on sépare du substrat n⁺, la couche n⁻ au moyen d'implantation de défauts et/ou la couche n⁺ par implantation de défauts.

8. Procédé de fabrication selon la revendication 1 ou 2, **caractérisé en ce que** la troisième couche comprend un métal ou un composé métallique ou est constituée d'un métal ou d'un composé métallique.
